# EUROPEAN PATENT APPLICATION

(11) **EP 4 679 946 A1**
(43) Date of publication of application: **14.01.2026**
(21) Application number: 24771169.0
(22) Date of filing: 12.03.2024
(51) Int. Cl.: H05K 1/14, H05K 1/02, H05K 9/00, G06F 1/16

(54) **ELECTRONIC DEVICE COMPRISING CONDUCTIVE PIN**

(30) Priority: 13.03.2023 KR 20230032689; 12.04.2023 KR 20230048420
(71) Applicant: Samsung Electronics Co., Ltd, Suwon-si, Gyeonggi-do 16677 (KR)
(72) Inventor: CHO, Yongwon, Suwon-si Gyeonggi-do 16677 (KR); YOON, Hyunjoong, Suwon-si Gyeonggi-do 16677 (KR)
(74) Representative: Gulde & Partner
(86) International application number: PCT/KR2024/003164
(87) International publication number: WO 2024/191170

(57) **Abstract**

According to one embodiment of the present invention, an electronic device may be provided. The electronic device may comprise: a housing; a display; a first conductive pin; a first circuit board disposed within the housing; a second circuit board disposed within the housing and positioned closer to the first conductive pin than the first circuit board; and a substrate assembly of which at least a portion is disposed between the second circuit board and the second portion. The first conductive pin may include: a first portion disposed in a through hole formed in one side of the housing: and the second portion extending from the first portion toward an inside of the housing. The substrate assembly may include: a flexible circuit board; at least one first conductive member disposed on the flexible circuit board and electrically connected to the second portion; and at least one second conductive member disposed on the flexible circuit board and electrically connected to the second circuit board.

## Description

### [Technical Field]

Embodiments of the disclosure relate to an electronic device including a conductive pin.

### [Background Art]

With the rapid advancement of information and communication technologies and semiconductor technologies, the distribution and use of various electronic devices have significantly increased. In particular, recent electronic devices have been developed to be portable and capable of communication.

The term "electronic device" may refer to a device that performs specific functions based on embedded programs, such as home appliances, electronic notes, portable multimedia players (PMPs), mobile communication terminals, tablet personal computers (PCs), video/audio devices, desktop or laptop computers, and vehicle navigation systems. For example, such electronic devices may output stored information as sound or images. As the integration level of electronic devices increases and ultra-high-speed, large-capacity wireless communication becomes widespread, various functions may be integrated into a single electronic device such as a mobile communication terminal. For example, not only communication functions, but also entertainment functions such as gaming, multimedia functions such as music or video playback, security functions such as mobile banking, and personal management functions such as scheduling or electronic wallets have been integrated into a single electronic device. Such electronic devices have also been miniaturized for convenient portability by users.

The above-described information may be provided as related art to assist in the understanding of the disclosure. No claim or determination is made as to whether any of the above constitutes prior art related to the disclosure.

### [Detailed Description of the Invention]

### [Technical Solution]

According to an embodiment of the disclosure, an electronic device may be provided. The electronic device may include a housing, a display, a first conductive pin, a first circuit board disposed in the housing, a second circuit board disposed in the housing and positioned closer to the first conductive pin than the first circuit board, and a board assembly at least partially disposed between the second circuit board and the second portion. The first conductive pin may include a first portion disposed in a through-hole formed on one side of the housing, and a second portion extending from the first portion toward an inside of the housing. The board assembly may include a flexible circuit board, at least one first conductive member disposed on the flexible circuit board and electrically connected to the second portion, and at least one second conductive member disposed on the flexible circuit board and electrically connected to the second circuit board.

According to an embodiment of the disclosure, an electronic device may be provided. The electronic device may include a housing, a display, a first conductive pin, a printed circuit board disposed in the housing, and a flexible circuit board at least partially disposed on the printed circuit board, at least one first conductive member one surface of the flexible circuit board and electrically connected to the second portion, and at least one second conductive member disposed on a surface of the flexible circuit board opposite to the one surface and electrically connected to the printed circuit board.

### [Brief Description of the Drawings]

The foregoing and other aspects, configurations, and/or advantages of an embodiment of the disclosure will be more apparent from the following detailed description taken in conjunction with the accompanying drawings.
FIG. 1 is a block diagram of an electronic device in a network environment according to an embodiment of the disclosure;
FIG. 2 is a perspective view illustrating an electronic device according to an embodiment of the disclosure;
FIG. 3 is a perspective view illustrating the electronic device shown in FIG. 2;
FIG. 4 is an exploded perspective view of an electronic device according to an embodiment of the disclosure;
FIG. 5 is a partial perspective view of an electronic device according to an embodiment of the disclosure;
FIG. 6 is a plan view showing part of the configuration of an electronic device according to an embodiment of the disclosure;
FIG. 7A is a plan view showing conductive pins, a conductive elastic member, and a flexible circuit board of an electronic device according to an embodiment of the disclosure;
FIG. 7B is a cross-sectional view taken along line A-A' of FIG. 7A;
FIG. 8 is a perspective view of a conductive pin of an electronic device according to an embodiment of the disclosure;
FIG. 9A is a side view of a board assembly of an electronic device according to an embodiment of the disclosure;
FIG. 9B is a plan view of the board assembly of FIG. 9A;
FIG. 9C is a rear view of the board assembly of FIG. 9A;
FIG. 10A is a plan view showing a second molded portion disposed on the board assembly of FIG. 7A;
FIG. 10B is a cross-sectional view taken along line B-B' of FIG. 10A;
FIG. 11A is a rear view showing a first circuit board and a flexible circuit board of an electronic device according to an embodiment of the disclosure;
FIG. 11B is a rear view showing a metal sheet of an electronic device according to an embodiment of the disclosure;
FIG. 12 is a partial perspective view of the electronic device as viewed from the rear side, according to an embodiment of the disclosure;
FIG. 13 is a side cross-sectional view of an electronic device according to an embodiment of the disclosure; and
FIG. 14 is a perspective view of a conductive pin according to an embodiment of the disclosure.

Throughout the accompanying drawings, similar reference numerals may be assigned to similar parts, components, and/or structures.

### [Mode for Carrying out the Invention]

Hereinafter, embodiments of the disclosure will be described in detail with reference to the drawings so that those skilled in the art can easily implement the disclosure. However, the disclosure may be embodied in various different forms and is not limited to the embodiments described herein. In the description of the drawings, the same or similar reference numerals may be used for the same or similar components. In addition, well-known functions and configurations may be omitted from the drawings and related descriptions for clarity and conciseness.

The electronic device according to various embodiments of the disclosure may be one of various types of devices. The electronic devices may include, for example, a portable communication device (e.g., a smartphone), a computer device, a portable multimedia device, a portable medical device, a camera, a wearable device, or a home appliance. The electronic devices according to an embodiment are not limited to those described above.

It should be appreciated that one embodiment of the disclosure and the terms used therein are not intended to limit the technological features set forth herein to portionicular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "portion," or "circuitry". A module may be a single integral component, or a minimum unit or portion thereof, adapted to perform one or more functions. For example, according to an embodiment, the module may be implemented in a form of an application-specific integrated circuit (ASIC).

An embodiment of the disclosure may be implemented as software (e.g., the program 140) including one or more instructions that are stored in a storage medium (e.g., internal memory 136 or external memory 138) that is leadable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium leadable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to an embodiment of the disclosure may be included and provided in a computer program product. The computer program products may be traded as commodities between sellers and buyers. The computer program product may be distributed in the form of a machine-readable storage medium (e.g., compact disc lead only memory (CD-ROM)), or be distributed (e.g., downloaded or uploaded) online via an application store (e.g., Play StoreTM), or between two user devices (e.g., smartphones) directly. If distributed online, at least portion of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities. Some of the plurality of entities may be separately disposed in different components. According to an embodiment, one or more of the above-described components may be omitted, or one or more other components may be added. Alternatively or further, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

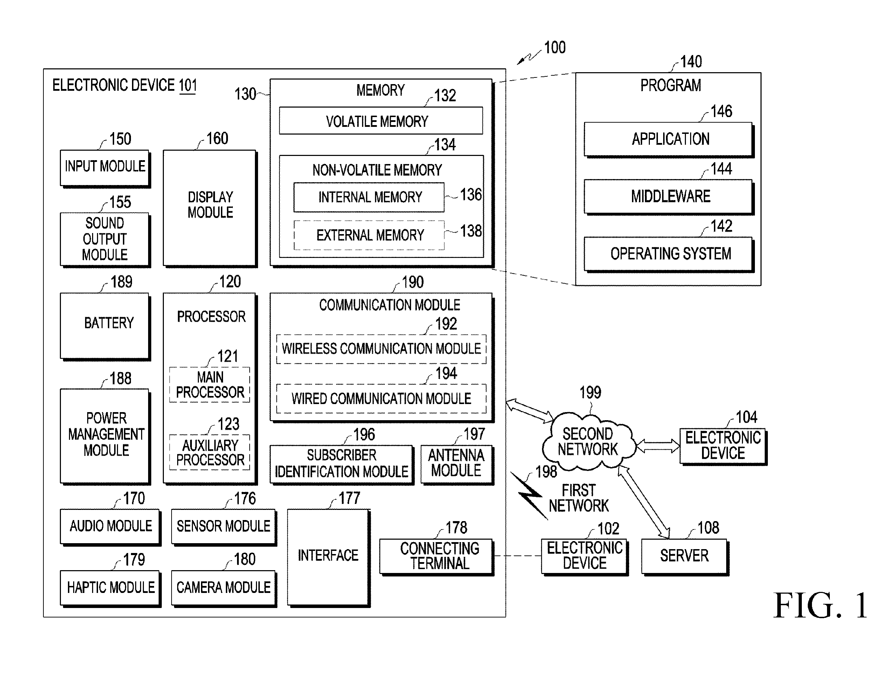

FIG. 1 is a block diagram illustrating an electronic device in a network environment 100 according to an embodiment of the disclosure.

Referring to FIG. 1, the electronic device 101 in the network environment 100 may communicate with an external electronic device 102 via a first network 198 (e.g., a short-range wireless communication network), or an external electronic device 104 or a server 108 via a second network 199 (e.g., a long-range wireless communication network). According to an embodiment, the electronic device 101 may communicate with the external electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. In an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least portion of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as portion of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as portion of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as portion of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a second sensor module configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., external electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the external electronic device 102) directly (e.g., wiredly) or wirelessly. According to an embodiment, the interface 177 may include, for example, a high-definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the external electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least portion of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the external electronic device 102, the external electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local region network (LAN) communication module or a power line communication (PLC) module). A corresponding one of these communication modules may communicate with the external electronic device 104 via a first network 198 (e.g., a short-range communication network, such as BluetoothTM, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local region network (LAN) or wide region network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beamforming, or large scale antenna. The wireless communication module 192 may support various requirements specified in the electronic device 101, an external electronic device (e.g., the external electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other portions (e.g., radio frequency integrated circuit (RFIC)) than the radiator may be further formed as portion of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least portion of the function or the service. The one or more external electronic devices receiving the request may perform the at least portion of the function or the service requested, or an additional function or an additional service related to the request, and transfer an outcome of the performing to the electronic device 101. The electronic device 101 may provide the outcome, with or without further processing of the outcome, as at least portion of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

In the following detailed description, reference may be made to the length direction, width direction, and/or thickness direction of the electronic device. The length direction may be defined as the "Y-axis direction," the width direction as the "X-axis direction," and the thickness direction as the "Z-axis direction." In an embodiment, regarding the orientation of components, the orthogonal coordinate system illustrated in the drawings may be used together with the notation of negative/positive (-/+) directions. For example, the front surface of the electronic device or housing may be defined as a surface facing the +Z direction, and the rear surface may be defined as a surface facing the -Z direction. In an embodiment, the side surfaces of the electronic device or housing may include regions facing the +X direction, +Y direction, -X direction, and/or -Y direction. In another embodiment, the term "X-axis direction" may refer to both the -X direction and the +X direction. It is noted that such descriptions are based on the orthogonal coordinate system shown in the drawings for the sake of simplicity, and descriptions of directions or components do not limit the scope of the embodiment of the disclosure. For example, depending on whether the electronic device is in a folded or unfolded state, the aforementioned front or rear surface may face different directions, and the described orientations may be interpreted differently depending on a user's holding habits.

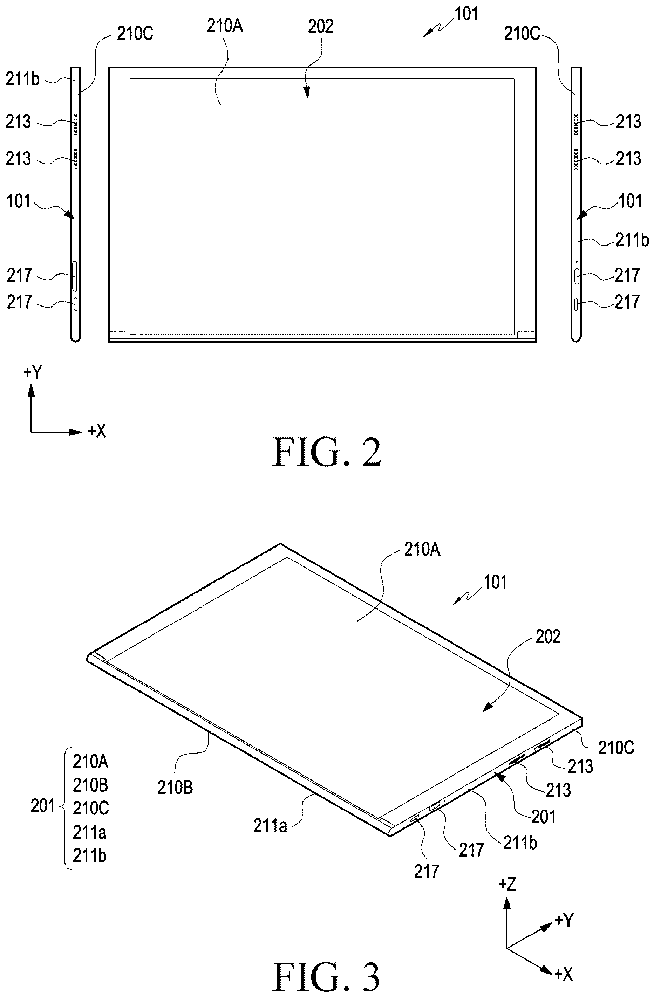

FIG. 2 is a three-view diagram illustrating an electronic device 101 according to an embodiment of the disclosure. FIG. 3 is a perspective view illustrating the electronic device 101 shown in FIG. 2. The configuration of the electronic device 101 in FIGS. 2 and 3 may be entirely or partially identical to the configuration of the electronic device 101 in FIG. 1.

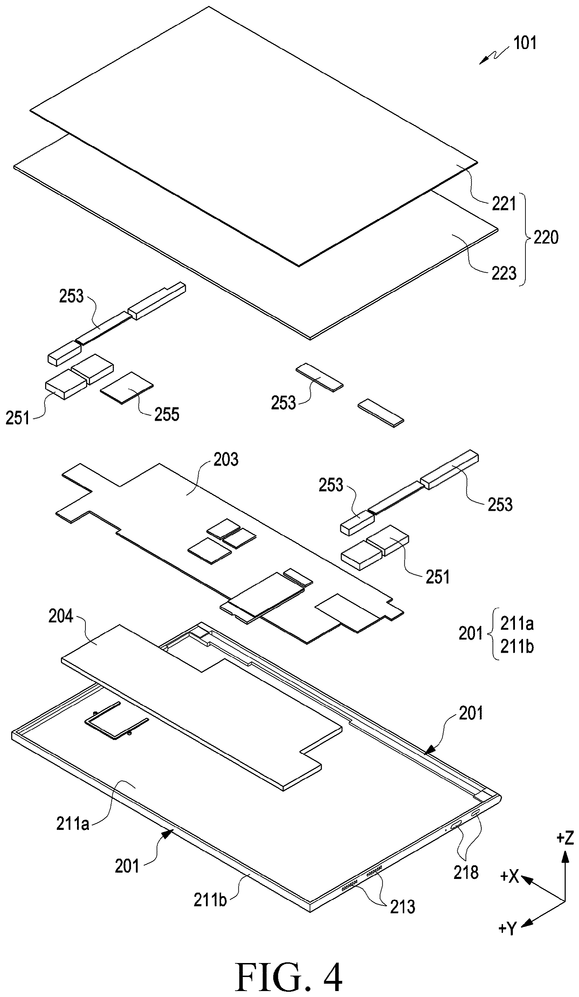

Referring to FIGS. 2 and 3, an electronic device 101 according to an embodiment may include a housing 201 including a first surface (or front surface) 210A, a second surface (or rear surface) 210B, and a side surface 210C surrounding a space between the first surface 210A and the second surface 210B. In an embodiment (not shown), the housing 201 may refer to a structure that forms at least a portion of the first surface 210A of FIG. 2, the second surface 210B of FIG. 3, and the side surface 210C. The electronic device 101 according to an embodiment (e.g., the electronic device 101 in FIG. 4) may include the housing 201, and, according to an embodiment, the first surface 210A may be at least partially formed by a substantially transparent front plate 202 (e.g., a glass plate including various coating layers, or a polymer plate). The front plate 202 may be referred to as, for example, a display (e.g., the display 220 of FIG. 4), a window, and/or a window plate (e.g., the window plate 221 of FIG. 4), and may form the exterior of the electronic device 101 together with the housing 201. According to an embodiment, the front plate 202 may be formed at least partially of a substantially transparent glass plate or polymer plate and may include various coating layers. In an embodiment, a display panel (e.g., the display panel 223 of FIG. 4) may be disposed on an inner surface of the front plate 202. Depending on the embodiment, the term "display" may refer to the front plate 202 itself and/or a combination of the front plate 202 and the display panel 223.

According to an embodiment, the second surface (or rear surface) 210B of the electronic device 101 may be formed by a rear plate 211a (e.g., the rear plate 211a of FIG. 4) provided as a part of the housing 201. The rear plate 211a may be formed of a substantially opaque material, for example, coated or tinted glass, ceramic, polymer, metal (e.g., aluminum, stainless steel (STS), or magnesium), or a combination of at least two of these materials.

According to an embodiment, the side surface 210C of the electronic device 101 may be formed by a side structure 211b (also referred to as a "bezel structure") that at least partially surrounds the space between the front plate 202 and the rear plate 211a. For example, the front plate 202 may be coupled to the side structure 211b and arranged to face the rear plate 211a with a certain distance therebetween. In an embodiment, the side structure 211b may be provided as a separate component from the rear plate 211a and may form the housing 201 by being coupled to the rear plate 211a through a separate assembly process. In an embodiment, the side structure 211b may be integrally manufactured or formed with the rear plate 211a and may include the same material (e.g., a metallic material such as aluminum). In an embodiment, the rear plate 211a and/or the side structure 211b may include, at least partially, an electrically conductive material, a metallic material, and/or a polymer material. When the rear plate 211a and/or the side structure 211b include an electrically conductive material, the housing 201 may at least partially function as an antenna for transmitting and receiving wireless signals and/or serve as a ground or electromagnetic shielding structure of the electronic device 101.

In the illustrated embodiment, the front plate 202 and/or the rear plate 211a has a substantially flat plate shape, however, it is noted that the embodiment disclosed herein is not limited thereto. For example, while the front plate 202 and/or the rear plate 211a may generally have a flat shape, at least a portion of their edges may be curved, and the side structure 211b that connects the edges of the front plate 202 and the rear plate 211a may also have a curved shape. In an embodiment, the thickness of the electronic device 101 measured along the Z-axis at a central portion of the front plate 202 may be greater than the thickness measured at an edge of the front plate 202. For example, the thickness of the electronic device 101 may gradually decrease toward the edge of the first surface 210A. When the front plate 202, the rear plate 211a, and/or the side structure 211b of the external appearance of the electronic device 101 have a curved shape, it may provide a comfortable grip for the user.

According to an embodiment, the electronic device 101 may include a display (e.g., the display 220 of FIG. 4), an audio module (e.g., the audio module 170 of FIG. 1), and/or a key input device 218, and may further include at least one of a sensor module (not shown; e.g., the sensor module 176 of FIG. 1), a camera module (e.g., the camera module 180 of FIG. 1), a light-emitting element, and a connector hole (e.g., the connection terminal 178 of FIG. 1). In an embodiment, the electronic device 101 may omit at least one of the above components (e.g., the key input device 218 or the light-emitting element) or additionally include other components.

The display 220 may be visually exposed through a substantial portion of the front plate 202, for example. In an embodiment, at least a portion of the display 220 may be visually exposed through the front plate 202 that forms the first surface 210A or through a part of the side surface 210C. In an embodiment, a corner of the display 220 may be formed to substantially match the adjacent outer shape of the front plate 202. In an embodiment (not shown), in order to expand the area through which the display 220 is visually exposed, the gap between the outer edge of the display 220 and the outer edge of the front plate 202 may be formed to be substantially uniform.

According to an embodiment, the display 220 may include a display panel (e.g., display panel 223 of FIG. 4) disposed inside the front plate 202 or the window plate 221 of FIG. 4, and may output visual information such as text, images, and/or video through a substantial portion of the front plate 202 and/or the window plate 221. In an embodiment, substantially the entire area of the front plate 202 may be set as a region for displaying the screen. The screen display region may be formed to substantially match the edge shape of the front plate 202. In an embodiment (not shown), the gap between the screen display region and the outer edge of the front plate 202 may be formed to be substantially uniform, thereby increasing the ratio of the screen display region within the area provided by the front plate 202.

In an embodiment, a recess or an opening may be formed in a portion of the screen display region of the display 220, and at least one of an audio module, a sensor module, a camera module, and a light-emitting element may be included to be aligned with the recess or opening. In an embodiment, the electronic device 101 may include at least one of an audio module, a sensor module, a camera module, a fingerprint sensor, and a light-emitting element arranged to face in a direction opposite to the screen output direction of the display 220. In an embodiment, while facing the same direction as the screen output direction, the electronic device may include at least one of an audio module, a sensor module, a camera module, and a light-emitting element disposed inside the screen display region of the display 220. For example, the camera module may be disposed to overlap the screen display region without being visually exposed to the outside, and may include a hidden under-display camera (UDC).

In an embodiment, the display 220 may be coupled with or disposed adjacent to a touch detection circuit, a pressure sensor capable of measuring the intensity (pressure) of a touch, and/or a digitizer for detecting a magnetic field-based stylus pen. In an embodiment, at least a portion of the sensor module and/or at least a portion of the key input device may be disposed inside the display.

In an embodiment, the display 220 may include a display (e.g., a flexible display) that is slidably disposed on the housing 201 to provide a screen (e.g., a screen display region). For example, the screen display region of the electronic device 101 refers to a region that is visually exposed and capable of outputting images, and the electronic device 101 may reduce or expand the screen display region according to the movement of a sliding plate (not shown) or the movement of the display 220. For example, the electronic device 101 may include a rollable-type electronic device configured to selectively expand the screen display region by allowing at least a portion (e.g., the housing) of the electronic device 101 to operate in a slidable manner at least partially. For instance, the display 220 may also be referred to as a slide-out display or an expandable display.

In an embodiment, the audio module may include a microphone hole and a speaker hole. A microphone may be disposed inside the microphone hole to acquire external sounds, and in an embodiment, a plurality of microphones may be arranged to detect the direction of the sound. The speaker hole may include an external speaker hole and a receiver hole for voice calls. In an embodiment, the speaker hole and the microphone hole may be implemented as a single hole, or a speaker may be included without a dedicated speaker hole (e.g., a piezoelectric speaker). In the illustrated embodiment, the audio module is shown as a hole 213 formed through the side 210C of the electronic device, for example, through the side structure 211b (e.g., the side structure 211b of FIG. 4); however, it should be noted that the embodiment of the disclosure is not limited thereto. For example, when providing a voice call function, the electronic device 101 may further include an audio module (not shown) in the form of a hole penetrating the front plate 202. The number and location of the audio modules may vary depending on the shape, function, and/or actual usage environment of the electronic device 101.

In an embodiment, a sensor module (not shown) may generate an electrical signal or data value corresponding to an internal operating state of the electronic device 101 or an external environmental condition. The sensor module may include, for example, sensors for detecting the operating environment of the electronic device 101, such as a proximity sensor, an illuminance sensor, or a temperature/barometric pressure sensor, and may further include sensors for acquiring the user's biometric information, such as a fingerprint sensor or an HRM sensor. In addition, various other types of sensors, such as a gesture sensor, gyroscopic sensor, magnetic sensor, acceleration sensor, grip sensor, color sensor, infrared (IR) sensor, or humidity sensor, may be mounted in the electronic device 101. The arrangement of such sensor modules may be appropriately selected in consideration of the actual usage environment of the electronic device and the functions installed therein.

In an embodiment, a camera module (not shown) may be disposed on at least one of the first surface 210A and the rear second surface 210B of the electronic device 101. According to an embodiment, a plurality of camera modules may be arranged to face the same direction. In an embodiment, the camera module may include a flash that provides illumination toward a subject. The camera module may include, for example, one or more lenses, an image sensor, and/or an image signal processor. The flash may include, for example, a light-emitting diode or a xenon lamp.

According to an embodiment, a key input device 218 may be disposed on a side surface 210C of the electronic device 101 and/or the housing 201. In an embodiment, the electronic device 101 may include some or none of the above-mentioned key input devices 218, and the omitted key input devices 218 may be implemented in other forms, such as soft keys on the display 220. The number and positions of the key input devices 218 are not limited to the illustrated embodiment and may be additionally provided on the first surface 210A, the second surface 210B, and/or the side surface 210C (not shown) of the electronic device. In an embodiment, some of the key input devices 218 shown in FIG. 2 may be replaced with a slot or connector hole. For example, the electronic device 101 may receive a user identity module card or memory card through a slot formed through the side structure 211b, and may transmit and receive power, audio signals, and/or data with an external electronic device through a connector hole.

According to an embodiment, a light-emitting element (not shown) may be disposed on the first surface 210A and/or the second surface 210B of the electronic device 101. The light-emitting element may provide status information of the electronic device 101 in the form of light. In an embodiment, the light-emitting element may provide a light source that operates in conjunction with the operation of a camera module, for example. The light-emitting element may include, for example, an LED, an IR LED, and a xenon lamp.

FIG. 4 is an exploded perspective view illustrating an electronic device 101 (e.g., the electronic device 101 of FIG. 2 and/or FIG. 3) according to an embodiment of the disclosure.

Referring to FIG. 4, the electronic device 101 may include a housing 201 (e.g., the housing 201 of FIG. 2 and/or FIG. 3), a display 220, a printed circuit board 203 (e.g., a PCB, printed board assembly (PBA), flexible PCB (FPCB), or rigid-flexible PCB (RFPCB)), a battery 204, and an antenna 253. According to an embodiment, the electronic device 101 may omit at least one of the components or may additionally include other components (e.g., a bracket for supporting or protecting the display 220). According to an embodiment, the electronic device 101 may include at least one hinge structure and may have a foldable structure in which housings divided into multiple regions are foldable. For example, depending on a change in the state of a hinge structure (e.g., a folded state, an intermediate state, or an unfolded state), the state of a display operatively connected to the housing may change. For instance, a first display corresponding to a first housing and a second display corresponding to a second housing may transition between facing each other and being spaced apart. According to an embodiment, at least one of the components of the electronic device 101 may be the same as or similar to at least one of the components of the electronic device 101 shown in FIG. 2 or FIG. 3, and redundant descriptions will be omitted below.

According to an embodiment, the housing 201 may include a rear plate 211a (e.g., the rear plate 211a of FIG. 2) and a side structure 211b (e.g., the side structure 211b of FIG. 2) extending in the thickness direction (e.g., the Z-axis direction) from the rear plate 211a. In an embodiment, the side structure 211b may be manufactured as a separate component from the rear plate 211a and may form the housing 201 by being coupled to the rear plate 211a. In an embodiment, the side structure 211b and the rear plate 211a may be integrally manufactured and formed as a single component. Although not illustrated, the housing 201 may further include a support member (not shown) that isolates the display 220 (e.g., the display panel 223) from the space in which the printed circuit board 203 or the battery 204 is accommodated, and the support member may be in the form of a flat plate integrally formed with the side structure 211b. In the embodiments described below, the rear plate 211a of FIG. 4 and the rear plate 211a of FIG. 3 may be interpreted as being substantially the same.

According to an embodiment, the rear plate 211a and/or the side structure 211b may be formed of a metal material and/or a non-metal (e.g., polymer) material. For example, the housing 201 may include an electrically conductive material at least partially. In an embodiment, when the rear plate 211a includes an electrically conductive material, the housing 201 may be utilized, at least in part, as a structure providing electromagnetic shielding. In an embodiment, when the side structure 211b includes an electrically conductive material, at least a portion of the side structure 211b may be utilized as a radiating conductor for transmitting and receiving radio frequency signals. In an embodiment, when a support member (not shown) is disposed between the printed circuit board 203 and the display panel 223 and the support member includes an electrically conductive material, the support member may serve as a ground conductor or an electromagnetic shielding structure for the electronic device 101.

According to an embodiment, a processor, memory, and/or an interface may be disposed on the printed circuit board 203, which is arranged as a first circuit board or a main circuit board. The processor may include one or more of a central processing unit (CPU), an application processor, a graphics processing unit (GPU), an image signal processor, a sensor hub processor, or a communication processor. In an embodiment, the processor or a communication module may be mounted on an electronic component 255, such as an integrated circuit chip, and disposed on the printed circuit board 203. For example, the electronic component 255 may be mounted on the printed circuit board 203 through a surface-mounting process, and may perform wireless communication using the antenna 253 and/or a portion of the side structure 211b. According to an embodiment, the electronic device 101 may include a storage device (e.g., memory), such as a hard disk drive (HDD) or a solid-state drive (SSD).

According to an embodiment, the memory may include, for example, volatile memory or non-volatile memory.

According to an embodiment, the interface may include, for example, a high definition multimedia interface (HDMI), a universal serial bus (USB) interface, an SD card interface, and/or an audio interface. The interface may electrically or physically connect the electronic device 101 to an external electronic device and may include, for example, a USB connector, an SD card/MMC connector, or an audio connector.

According to an embodiment, the battery 204 may be a device configured to supply power to at least one component of the electronic device 101 and may include, for example, a non-rechargeable primary battery, a rechargeable secondary battery, or a fuel cell. At least a portion of the battery 204 may be disposed, for example, on substantially the same plane as the printed circuit board 203. The battery 204 may be integrally disposed within the electronic device 101 or may be detachably mounted to the electronic device 101.

According to an embodiment, the antenna 253 may be disposed inside the housing 201 adjacent to an edge, for example, the side structure 211b. In an embodiment, a plurality of antennas 253 may be arranged at appropriate positions along the edge inside the housing 201. In an embodiment, the illustrated antenna 253 may perform millimeter wave (mmWave) communication using frequencies of several tens of GHz or higher. In an embodiment, although not shown, the electronic device 101 may further include a plate-shaped antenna disposed between the rear plate 211a and the battery 204. The plate-shaped antenna may include a wire or printed circuit pattern arranged on a plane to form a loop structure, and may function, for example, as a near field communication (NFC) antenna, a wireless charging antenna, and/or a magnetic secure transmission (MST) antenna. For example, the plate-shaped antenna may perform short-range communication with an external device or transmit and receive power wirelessly for charging.

According to an embodiment, the display 220 may include a window plate 221 (e.g., the front plate 202 of FIG. 2 or FIG. 3) and a display panel 223. The display panel 223 is disposed on an inner surface of the window plate 221 and may output visual information using substantially the entire area of the window plate 221.

According to an embodiment, the electronic device 101 may include a plurality of through-holes 213 and 217 formed through the side structure 211b. Among the plurality of through-holes 213 and 217, the first through-hole(s) 213 may serve as a path for outputting sound. For example, the audio module of FIG. 2 or FIG. 3 may include the first through-hole 213. In an embodiment, the electronic device 101 may include at least one speaker module 251 disposed at a position corresponding to the first through-hole(s) 213, and the speaker module 251 may output sound to the outside of the electronic device 101 through the first through-hole(s) 213. Among the plurality of through-holes 213 and 217, the second through-hole(s) 217 may provide space for installing an input device, such as the key input device 218 of FIG. 2 or FIG. 3. In an embodiment, some of the plurality of through-holes 213 and 217 may serve as slots for accommodating storage media or as connector holes. Depending on the embodiment, additional slots and/or connector holes may be formed through the side structure 211b.

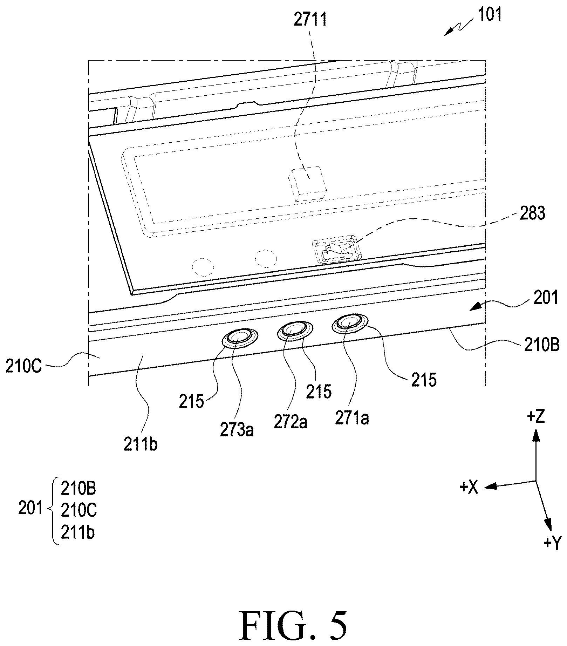

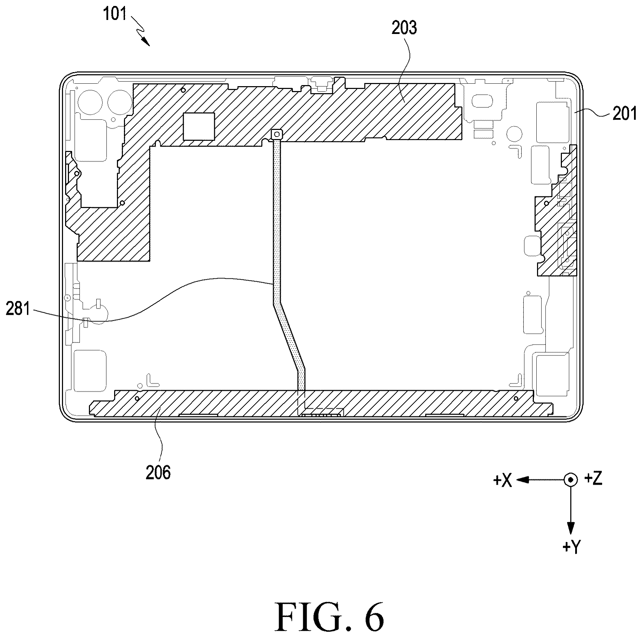

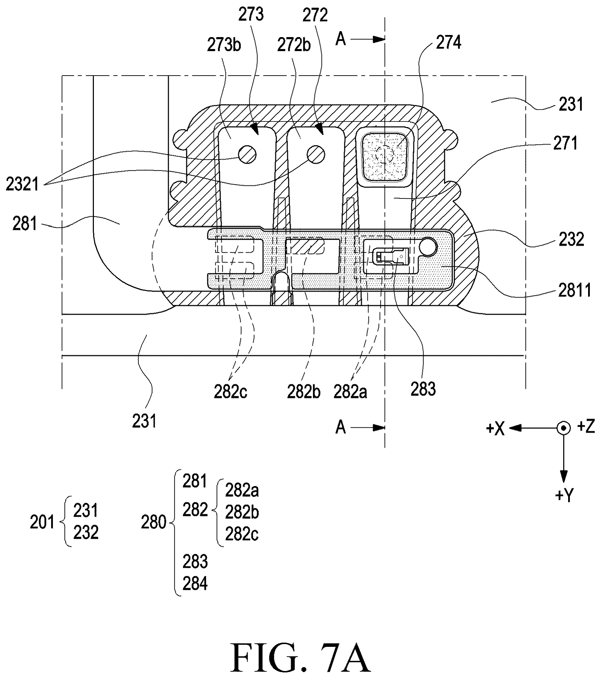

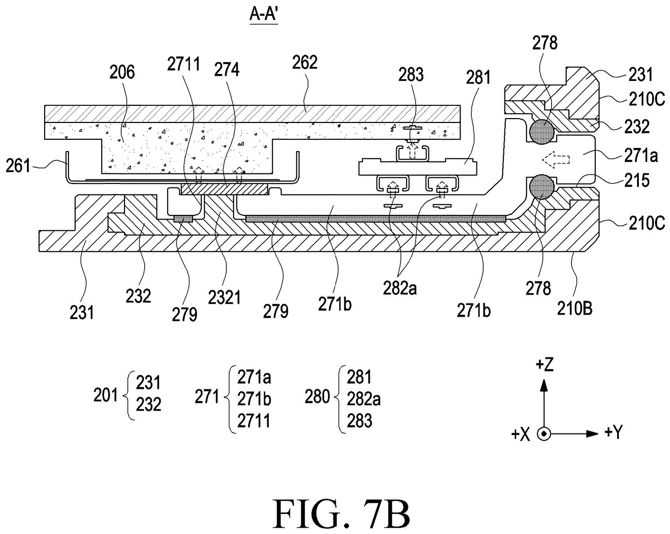

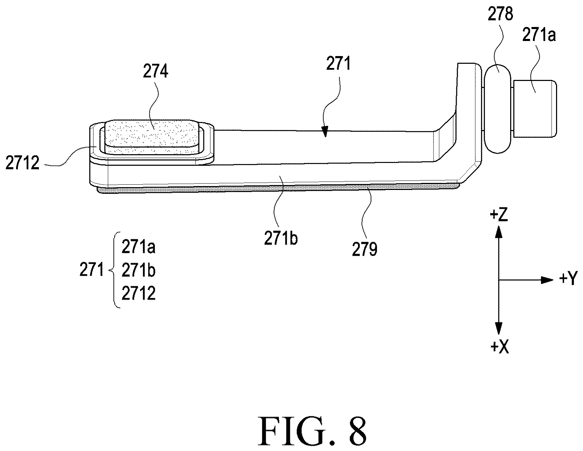

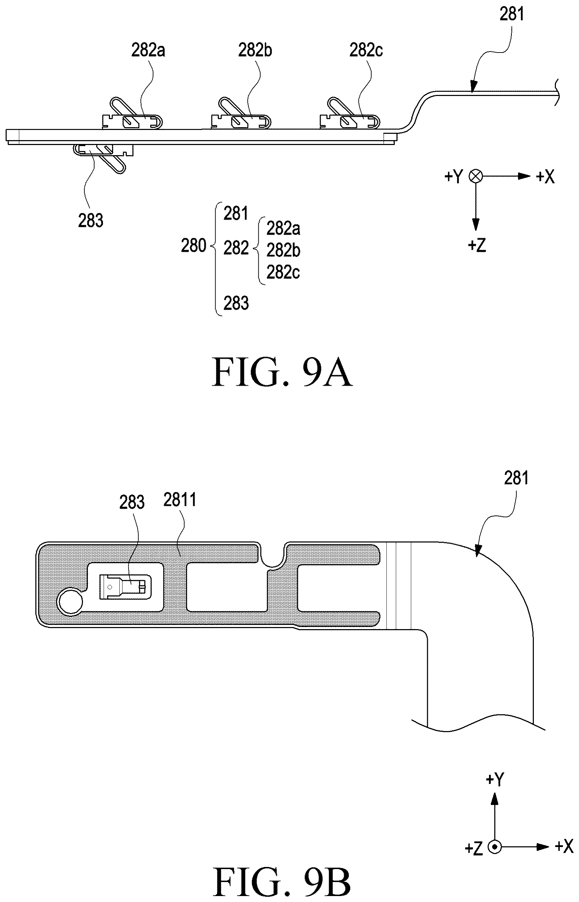

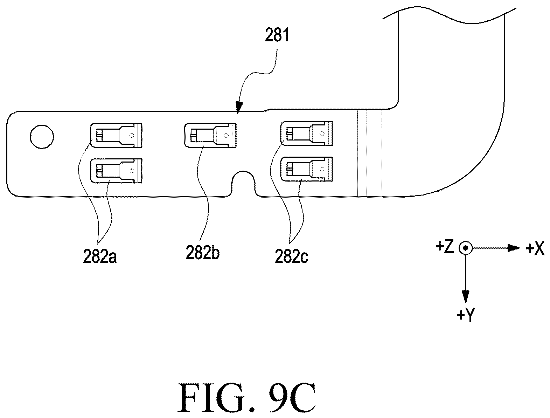

FIG. 5 is a partial perspective view of an electronic device according to an embodiment of the disclosure. FIG. 6 is a plan view showing a part of the configuration of an electronic device according to an embodiment of the disclosure. FIG. 7A is a plan view showing conductive pins, a conductive elastic member, and a flexible circuit board of an electronic device according to an embodiment of the disclosure. FIG. 7B is a cross-sectional view taken along line A-A' of FIG. 7A. FIG. 8 is a perspective view of a conductive pin of an electronic device according to an embodiment of the disclosure. FIG. 9A is a side view of a board assembly of an electronic device according to an embodiment of the disclosure. FIG. 9B is a plan view of the board assembly of FIG. 9A. FIG. 9C is a rear view of the board assembly of FIG. 9A.

The configuration of the electronic device 101 in FIGS. 5 and 6 may be entirely or partially the same as, or similar to, the configuration of the electronic devices 100 and 200 in FIGS. 2 to 4.

Referring to FIGS. 5 to 7B, in an embodiment, the electronic device 101 may include a housing 201, a display (e.g., the display 220 of FIG. 4), a first circuit board (e.g., the printed circuit board 203 of FIG. 4), a second circuit board 206, a board assembly 280, and a plurality of conductive pins 271, 272, and 273 (e.g., pogo pins). According to an embodiment, the electronic device 101 may include a conductive elastic member 274 (e.g., conductive sponge) disposed on one of the plurality of conductive pins 271, 272, and 273 (e.g., the first conductive pin 271). In FIGS. 5 to 7B, illustration of certain components of the electronic device 101, such as the battery (e.g., the battery 204 of FIG. 4), may be omitted. According to embodiments of the disclosure described below, the electronic device 101 may include a grounding structure composed of a combination (or coupling) of at least one of the conductive pins 271, 272, and 273 (e.g., the first conductive pin 271), the conductive elastic member 274, and the board assembly 280, and the grounding structure may provide a discharge function for external electrostatic charges introduced through the first conductive pin 271.

In an embodiment, the housing 201 may provide a space to accommodate electrical/electronic components (e.g., the battery 204 of FIG. 4). According to an embodiment, the housing 201 may include a side structure 211b (e.g., the side structure 211b of FIGS. 2 to 4) forming the side surface 210C of the electronic device 101. According to an embodiment, the housing 201 may include a rear plate 211a (e.g., the rear plate 211a of FIG. 4) facing the second surface (or rear surface) 210B of the electronic device 101. For example, the side structure 211b and the rear plate 211a (e.g., the rear plate 211a of FIG. 4) of the housing 201 may be integrally manufactured or formed, or may be separately manufactured or formed and then coupled together. According to an embodiment, the housing 201 may include a first region 231 (e.g., metal), which is conductive, and a second region 232 (e.g., polymer), which is non-conductive. According to an embodiment, the first region 231 and the second region 232 may be integrally manufactured or formed. For example, the second region 232 may be injection-molded onto the first region 231. According to an embodiment, the display 220 may be arranged to face the first surface (or front surface) of the electronic device 101 (e.g., the first surface 210A of FIG. 2).

Referring to FIG. 5, in an embodiment, the housing 201 may include a plurality (e.g., three) of through-holes 215 formed in the side structure 211b (or side frame). According to an embodiment, a portion (e.g., a first portion 271a) of each of the plurality of conductive pins 271, 272, and 273 may be received in a respective through-hole 215 of the housing 201. For example, the through-holes 215 may be arranged to be spaced apart from each other and may form a single row or multiple rows.

In an embodiment, the second circuit board 206 may be disposed in the housing 201 and may be electrically connected to the display panel (e.g., the display panel 223 of FIG. 4). In an embodiment, the second circuit board 206 (e.g., a printed circuit board (PCB) and/or a printed board assembly (PBA)) may be arranged closer to the conductive pins 271, 272, and 273 than the first circuit board (e.g., the printed circuit board 203 of FIG. 4). According to an embodiment, the second circuit board 206 may be positioned closer to the display (e.g., the display 220 of FIG. 4) than the flexible circuit board 281. For example, the second circuit board 206 and the conductive pins 271, 272, and 273 may be arranged adjacent to opposite sides of one side of the electronic device 101 to which the first circuit board 203 is adjacent. In an embodiment, the second circuit board 206 may at least partially overlap the conductive pins 271, 272, and 273 (e.g., the first conductive pin 271) along an axis (or direction), such as the direction in which the display faces or the Z-axis direction.

In an embodiment, a shielding member 261 (e.g., a shield can) may be disposed on one surface of the second circuit board 206. According to an embodiment, the shielding member 261 may be disposed on a rear surface (e.g., the -Z direction surface) of the second circuit board 206. In an embodiment, the shielding member 261 may at least partially face a second portion 271b of the conductive pins 271, 272, and 273 (e.g., the first conductive pin 271). For example, the shielding member 261 may be coupled to the second circuit board 206 by surface mounting (e.g., soldering).

According to an embodiment, the electronic device 101 may further include a digitizer module (not shown) configured to detect a touch sensing circuit, a pressure sensor capable of measuring the intensity (pressure) of a touch, and/or a magnetic field-based stylus pen. Referring to FIG. 7B, according to an embodiment, a metal sheet 262 may be understood to be a component included in the digitizer module (not shown). According to an embodiment, the display (e.g., the display 220 of FIG. 4) or the display panel (e.g., the display panel 223 of FIG. 4) may be coupled to or disposed adjacent to the digitizer module (not shown). According to an embodiment, the metal sheet 262 may be disposed on the second circuit board 206 and may be electrically connected to a ground region of the second circuit board 206. For example, the metal sheet 262 may be a metal (e.g., aluminum) plate member. According to an embodiment, the metal sheet 262 may be configured to maintain the rigidity of the display 220, the digitizer circuit board, and/or a shielding sheet (not shown) provided between the display 220 and the digitizer circuit board. However, the material, shape, and/or arrangement of the metal sheet 262 are not limited to the above description. According to an embodiment, the metal sheet 262 may maintain the function of providing a conductive region electrically connected to the first conductive pin 271a through the shielding member 261 and/or the conductive members 282a and 283, while its material, shape, and/or arrangement may be changed as needed. In an embodiment, the metal sheet 262 may form part not only of the digitizer module (not shown) but also of electrical/electronic components (e.g., a wireless charging module) or a support structure of the electronic device 101.

Referring to FIGS. 6 to 7B and FIGS. 9A to 9C, in an embodiment, at least a portion of the board assembly 280 may be located between the conductive pins 271, 272, and 273 and the second circuit board 206. In an embodiment, the board assembly 280 may include a flexible circuit board 281 (e.g., a flexible printed circuit board (FPCB) and/or a rigid-flexible printed circuit board (RFPCB)), a first conductive member 282 (e.g., a C-clip), and a second conductive member 283 (e.g., a C-clip), which are disposed on the flexible circuit board 281.

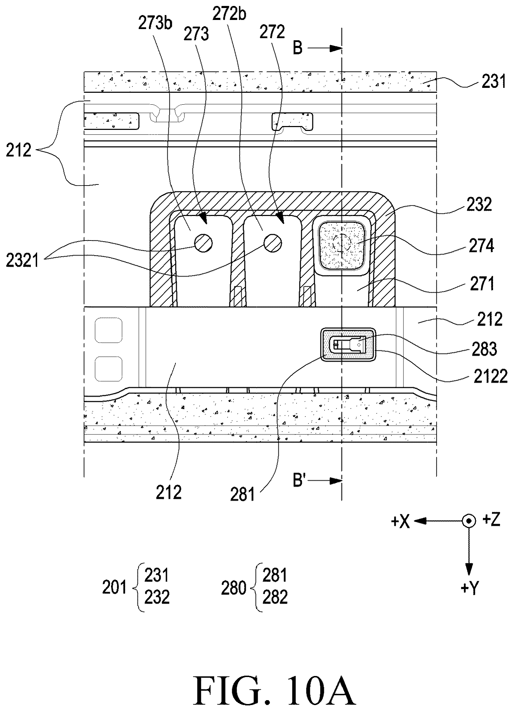

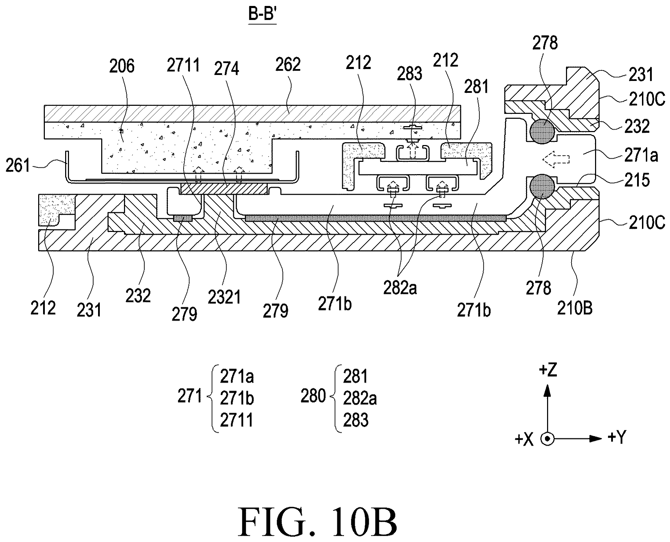

In an embodiment, the flexible circuit board 281 may be configured to electrically connect the conductive pins 271, 272, and 273 to the first circuit board (e.g., the printed circuit board 203 of FIG. 4). In an embodiment, the first circuit board 203 and the conductive pins 271, 272, and 273 may be disposed adjacent to opposite sides of the side surface 210C of the electronic device 101, and the flexible circuit board 281 may extend between the first circuit board 203 and the conductive pins 271, 272, and 273. According to an embodiment, the flexible circuit board 281 may at least partially overlap the second circuit board 206 and/or the conductive pins 271, 272, and 273 (e.g., the first conductive pin 271) along an axis or direction, for example, such as the direction in which the display faces or the Z-axis direction. Referring to FIGS. 7A and 9B, in an embodiment, an adhesive layer 2811 (e.g., an adhesive or double-sided tape) may be provided around the second conductive member 283 on the front surface of the flexible circuit board 281 where the second conductive member 283 is disposed. As will be described below with reference to FIGS. 10A and 10B, the adhesive layer 2811 may connect the flexible circuit board 281 to the non-conductive member 212.

In an embodiment, the first conductive member 282 and the second conductive member 283 may be mounted on different surfaces of the flexible circuit board 281. Referring to FIGS. 7A, 7B, and 9A through 9C, according to an embodiment, the first conductive member 282 may be disposed on one surface (or rear surface) of the flexible circuit board 281 that faces the conductive pins 271, 272, and 273. According to an embodiment, the second conductive member 283 may be disposed on the opposite surface of the flexible circuit board 281 from the surface where the first conductive member 282 is mounted, or on the other surface (or the front surface) of the flexible circuit board 281 that faces the display. For example, the first conductive member 282 may be located between the conductive pins 271, 272, and 273 and the flexible circuit board 281. For example, the second conductive member 283 may be located between the flexible circuit board 281 and the second circuit board 206. According to an embodiment, the first conductive member 282 may be disposed to electrically connect the conductive pins 271, 272, and 273 to the flexible circuit board 281. According to an embodiment, the second conductive member 283 may be disposed to electrically connect the flexible circuit board 281 to the second circuit board 206. According to an embodiment, the first conductive member 282 and the second conductive member 283 may extend a ground region electrically connected to the first conductive pin 271 to the ground region of the second circuit board 206 and to the metal sheet 262. The first conductive member 282 and/or the second conductive member 283 may be coupled, for example, by surface mounting (e.g., soldering) onto the flexible circuit board 281.

Referring to FIG. 7B, in an embodiment, the plurality of conductive pins 271, 272, and 273 may be disposed adjacent to the second plate (e.g., the rear plate 211a of FIG. 4) that forms the rear surface 210B of the electronic device 101 or the housing 201. For example, the conductive pins 271, 272, and 273 may be connection members or connectors such as pogo pins, a portion of which is exposed to the outside of the electronic device 101. According to an embodiment, the conductive pins 271, 272, and 273 may be disposed side by side or spaced apart from each other in parallel.

Referring to FIGS. 7A to 8, in an embodiment, each of the conductive pins 271, 272, and 273 may include a first portion 271a, 272a, 273a and a second portion 271b, 272b, 273b. According to an embodiment, the first portions 271a, 272a, 273a and the second portions 271b, 272b, 273b of the conductive pins 271, 272, and 273 may be seated in the second region 232 (or a non-conductive region) of the housing 201. In an embodiment, the first portions 271a, 272a, and 273a of the conductive pins 271, 272, and 273 may be disposed in the through-holes 215 of the side structure 211b that forms the side surface 210C of the electronic device 101, and at least a portion thereof may be exposed to the outside of the electronic device 101. According to an embodiment, at least some of the first portions 271a, 272a, 273a of the conductive pins 271, 272, and 273 may be electrically connected to, or connectable with, connectors provided in external electronic devices such as a wireless charging device (e.g., a charging dock) or an input device (e.g., a keyboard). In an embodiment, a ring-shaped waterproof member 278 may be disposed around the first portion 271a of the conductive pin 271. For example, the waterproof member 278 may be formed of an elastic material and may be configured to seal a gap between the first portion 271a and the through-hole 215.

In an embodiment, the second portions 271b, 272b, and 273b of the conductive pins 271, 272, and 273 may extend inward from the first portions 271a, 272a, and 273a toward the inside of the electronic device 101. According to an embodiment, the extension direction (e.g., the Y-axis direction) of the first portions 271a, 272a, and 273a may be aligned with (e.g., parallel to) the extension direction (e.g., the Y-axis direction) of the second portions 271b, 272b, and 273b. Referring to FIGS. 7A and 7B, in an embodiment, the conductive pins 271, 272, and 273 may include a coupling region 2711 (e.g., a hole or recess) formed in the second portions 271b, 272b, and 273b to receive a protrusion 2321 of the second region 232. For example, the coupling region 2711 may be a hole formed through the thickness direction (e.g., the Z-axis direction) of the second portion 271b. For example, the conductive pins 271, 272, and 273 may be seated and/or fixed to a portion of the second region 232 that forms the inner surface (e.g., the +Z direction surface) of the rear plate 211a. According to an embodiment, an adhesive member 279 such as an adhesive or double-sided tape may be provided between the second portions 271b, 272b, and 273b of the conductive pins 271, 272, and 273 and the inner surface (e.g., the +Z direction surface) of the rear plate 211a of the housing 201. According to an embodiment, each of the conductive pins 271, 272, and 273 may be electrically connected to the flexible circuit board 281 through a plurality of first conductive members 282 (e.g., C-clips) that are in contact with the second portion 271b of the corresponding conductive pin. According to an embodiment, the conductive pins 271, 272, and 273 may be electrically connected to the first circuit board (e.g., the printed circuit board 203 of FIG. 4) through the flexible circuit board 281.

Referring to FIGS. 7A to 8, in an embodiment, the plurality (e.g., three) of conductive pins 271, 272, and 273 may include a first conductive pin 271, a second conductive pin 272, and a third conductive pin 273. According to an embodiment, the first conductive pin 271 may serve as a ground terminal and may be grounded to the ground of the first circuit board (e.g., the printed circuit board 203 of FIG. 4) through the flexible circuit board 281. According to an embodiment, the second conductive pin 272 and/or the third conductive pin 273 may be configured to receive power from an external electronic device or to transmit and/or receive data such as input signals. According to an embodiment, the conductive pins 271, 272, and 273 may be configured to be electrically separated or isolated from each other.

Referring to FIG. 8, in an embodiment, a seating region 2712 (e.g., a recess) in which the conductive elastic member 274 is disposed may be formed in the second portion 271b of the first conductive pin 271. According to an embodiment, the seating region 2712 of the first conductive pin 271 may be connected to the coupling region 2711 and may be overlapped and/or be aligned with the coupling region 2711 in the thickness direction (e.g., the Z-axis direction) of the second portion 271b.

Referring to FIGS. 7A to 8, in an embodiment, the conductive elastic member 274 may be positioned between the shielding member 261 and the first conductive pin 271. According to an embodiment, the conductive elastic member 274 may be disposed on the first conductive pin 271, at a position corresponding to the shielding member 261. In an embodiment, the conductive elastic member 274 may be disposed in a seating region 2712 formed in the second portion 271b of the first conductive pin 271. According to an embodiment, the conductive elastic member 274 may be in contact with the shielding member 261 and maybe elastically deformed by the shielding member 261, for example. According to an embodiment, the conductive elastic member 274 may be electrically connected to the first conductive pin 271 and the shielding member 261. According to an embodiment, the conductive elastic member 274 may extend the ground region electrically connected to the first conductive pin 271 to the shielding member 261, and to the ground region of the second circuit board 206 electrically connected to the shielding member 261, and to the metal sheet 262.

According to embodiments of the disclosure, the electronic device 101 may include a grounding structure or electrostatic discharge (ESD) structure in which the first conductive pin 271 is grounded to the metal sheet 262 of a digitizer module (not shown) through the board assembly 280 and/or the conductive elastic member 274. Here, the metal sheet 262 may be electrically connected to the ground of the second circuit board 206. In FIG. 7B, the electrical flow of external static electricity introduced from outside the electronic device 101 is indicated by arrows. Referring to FIG. 7B, according to an embodiment, external static electricity introduced into the first portion 271a of the first conductive pin 271 may flow to the second portion 271b. According to an embodiment, the external static electricity transferred to the second portion 271b may be delivered through the first conductive member 282 to the flexible circuit board 281, the second conductive member 283, and a ground region (not shown) of the second circuit board 206, and may ultimately be transferred to and discharged through the metal sheet 262. According to an embodiment, the external static electricity transferred to the second portion 271b may be transferred to the shielding member 261 through the conductive elastic member 274, and may ultimately be transferred and discharged to the metal sheet 262 through a ground region of the second circuit board 206.

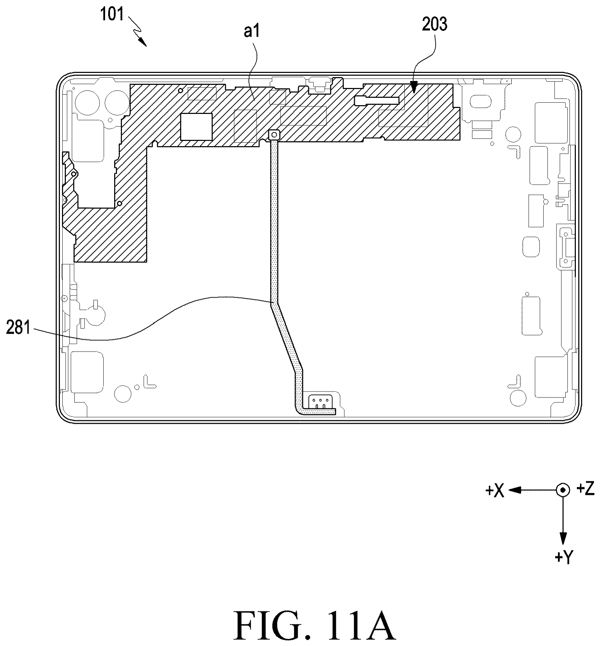

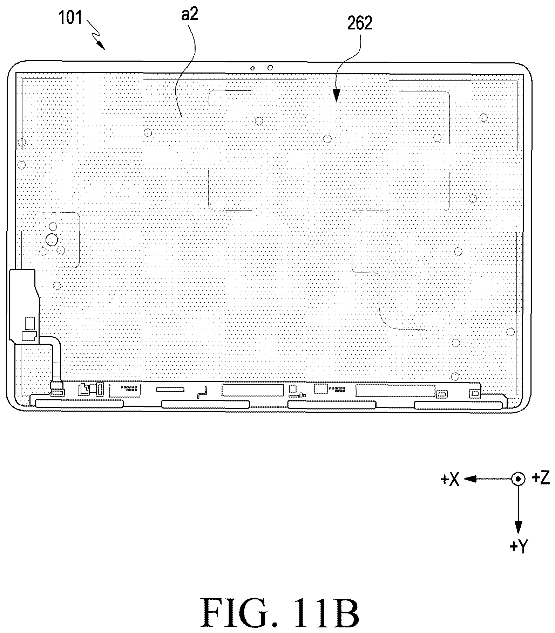

FIG. 10A is a plan view showing a state in which a second injection part is disposed on the board assembly of FIG. 7A. FIG. 10B is a cross-sectional view taken along line B-B' of FIG. 10A. FIG. 11A is a rear view showing a first circuit board and a flexible circuit board of the electronic device according to an embodiment of the disclosure. FIG. 11B is a rear view showing a metal sheet of the electronic device according to an embodiment of the disclosure.

Referring to FIGS. 10A and 10B, in an embodiment, the electronic device 101 may further include a non-conductive member 212 formed to at least partially surround the board assembly 280. According to an embodiment, at least a portion of the non-conductive member 212 may be disposed between the conductive pins 271, 272, 273 and the second circuit board 206. According to an embodiment, the non-conductive member 212 may include an opening 2122 formed at a location corresponding to the second conductive member 283. For example, the second conductive member 283 may be exposed outside the non-conductive member 212 through the opening 2122 and electrically connected to the second circuit board 206, and may be in contact with a portion of the second circuit board 206, for example. According to an embodiment, the non-conductive member 212 may be configured to physically and/or electrically isolate or insulate the non-conductive members of the board assembly 280 from surrounding structures and/or electrical/electronic components. For example, the non-conductive member 212 may prevent the non-conductive members from being short-circuited by conductive areas disposed nearby, such as metal areas of electrical/electronic components.

Referring to FIGS. 11A and 11B, the ground region of the first circuit board (e.g., the printed circuit board 203 of FIG. 4), which is electrically connected or grounded to the first conductive pin 271 (e.g., the first conductive pin 271 of FIGS. 5 and 7A to 8A) of the board assembly 280 (e.g., the board assembly 280 of FIGS. 7A, 7B, and 9A to 9C) according to the embodiment of FIGS. 5 to 10B, may be indicated as a1. Referring to FIG. 11B, the ground region of the metal sheet 262 (e.g., the metal sheet 262 of FIGS. 7B and 10B), which is electrically connected or grounded to the first conductive pin 271 according to the embodiment of FIGS. 5 to 10B, may be indicated as a2. Referring to FIGS. 11A and 11B, according to an embodiment of the disclosure, as an electrical path through which external static electricity introduced from outside the electronic device 101 is discharged via the first conductive pin 271, in addition to the electrical path in which the external static electricity is transferred to the first circuit board 203 through the flexible circuit board 281, an additional electrical path may be provided in which the external static electricity is transferred to the metal sheet 262 (e.g., the metal sheet 262 of FIGS. 7B and 10B) through the board assembly 280 and/or the conductive elastic member 274. According to an embodiment, by distributing external static electricity through the additional electrical path using the board assembly 280 and/or the conductive elastic member 274, the amount of external static electricity reaching the first circuit board 203 may be reduced, and the influence of the external static electricity on electrical/electronic components (e.g., the power management module 188 of FIG. 1) disposed on or near the first circuit board 203, as well as the risk of malfunction or damage to those components, may also be reduced. Referring to FIGS. 11A and 11B, the metal sheet 262 may provide a ground region a2 having a larger area compared to the ground region a1 of the first circuit board (e.g., the printed circuit board 203 of FIG. 4). However, the shape and/or layout of the metal sheet 262 and its ground region a2 are not limited to the description above. According to an embodiment, while maintaining the function of providing a conductive region electrically connected to the first conductive pin 271a through the shielding member 261 and/or the conductive members 282a and 283, the shape and/or layout of the metal sheet 262 and its ground region a2 may be modified as needed.

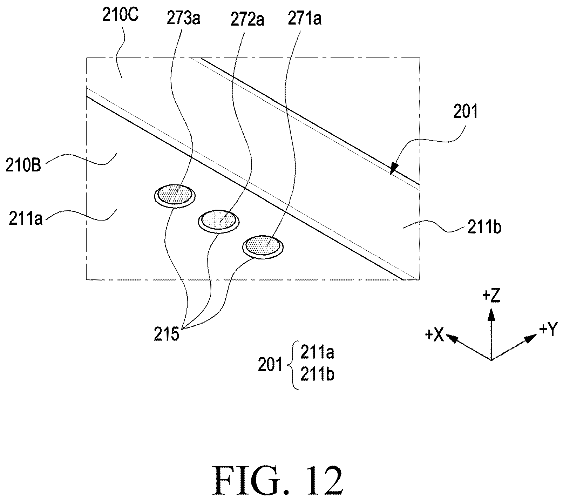

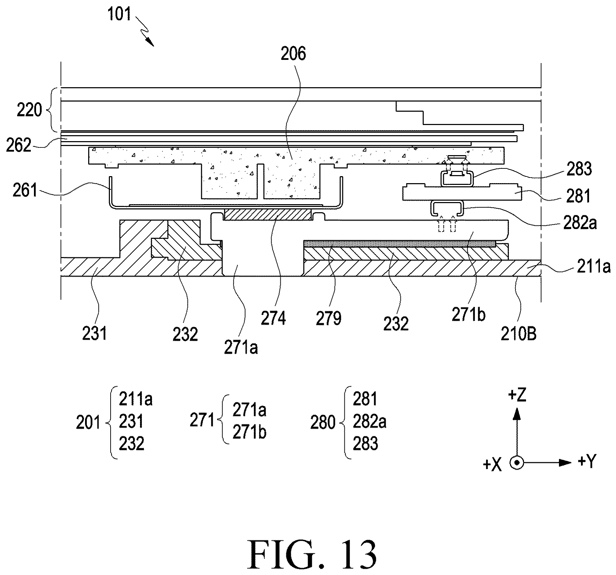

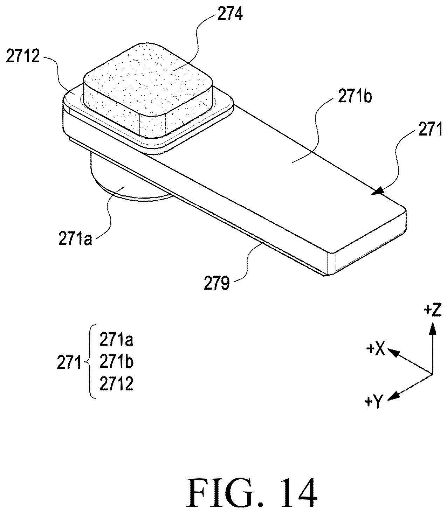

FIG. 12 is a partial perspective view of the electronic device as viewed from the rear side, according to an embodiment of the disclosure. FIG. 13 is a side cross-sectional view of the electronic device according to an embodiment of the disclosure. FIG. 14 is a perspective view of a conductive pin according to an embodiment of the disclosure.

The configuration of the electronic device 101 of FIG. 13 may be entirely or partially identical or similar to that of the electronic device 101 of FIGS. 1 to 6. The housing 201 of FIG. 12 may be entirely or partially identical to the housing 201 according to the embodiments of FIGS. 5 to 11B, except for the position of the through-holes 215. The conductive pins 271, 272, and 273 of FIGS. 13 and 14 may be entirely or partially identical to the conductive pins 271, 272, and 273 according to the embodiments of FIGS. 5 to 11B, except for the shape of the first portion 271a. The board assembly 280 of FIGS. 13 and 14 may be referenced as the board assembly 280 of FIGS. 7A, 7B, and 9A to 10B. The conductive elastic member 274 of FIGS. 14 and 15 may be referenced as the conductive elastic member 274 of FIGS. 5, 7A to 8, and 10A and 10B. With respect to the components assigned the same reference numerals in FIGS. 12 to 14, the descriptions provided with reference to FIGS. 5 to 11B may apply, and redundant descriptions may be omitted below. The following description with reference to FIGS. 12 to 14 may focus on differences from the embodiments of FIGS. 5 to 11B.

Referring to FIGS. 12 and 13, in an embodiment, the electronic device 101 (e.g., the electronic device 101 of FIGS. 1 to 4 and/or FIGS. 5 and 6) may include a housing 201, a display 220 (e.g., the display 220 of FIG. 4), a first circuit board (e.g., the printed circuit board 203 of FIG. 4), a second circuit board 206 (e.g., the second circuit board 206 of FIGS. 6, 7B, and 10B), a plurality of conductive pins 271, 272, and 273 (e.g., pogo pins), and a board assembly 280 (e.g., the board assembly 280 of FIGS. 7A, 7B, and 9A to 10B). In an embodiment, the electronic device 101 may include a conductive elastic member 274 (e.g., the conductive elastic member 274 of FIGS. 5, 7A to 8, and 10A and 10B) disposed on one of the plurality of conductive pins 271, 272, and 273 (e.g., the first conductive pin 271). In FIG. 5, certain components of the electronic device 101, such as the battery (e.g., the battery 204 of FIG. 4), may be omitted from the illustration. According to embodiments of the disclosure, the electronic device 101 may include a grounding structure composed of a combination (or coupling) of at least one of the conductive pins 271, 272, and 273 (e.g., the first conductive pin 271), the conductive elastic member 274, and the board assembly 280, and the grounding structure may provide a discharge function for external electrostatic discharge introduced through the first conductive pin 271.

Referring to FIGS. 12 and 13, in an embodiment, the housing 201 may be formed to provide a mounting space for electrical/electronic components (e.g., the battery 204 of FIG. 4). According to an embodiment, the housing 201 may include a side structure 211b (e.g., the side structure 211b of FIGS. 2 to 4) that forms the side surface 210C of the electronic device 101. According to an embodiment, the housing 201 may include a rear plate 211a (e.g., the rear plate 211a of FIG. 4) facing the second surface (or rear surface) 210B of the electronic device 101. For example, the side structure 211b and the rear plate 211a (e.g., the rear plate 211a of FIG. 4) of the housing 201 may be integrally manufactured or formed, or they may be separately manufactured or formed and then combined. According to an embodiment, the housing 201 may include a first region 231 (e.g., metal), which is conductive and a second region 232 (e.g., polymer), which is non-conductive. For example, the second region 232 may be injection-molded onto the first region 231. According to an embodiment, the display 220 may be disposed to face a first surface (or front surface) 210A of the electronic device 101 (e.g., the first surface 210A of FIG. 2).

Referring to FIG. 12, in an embodiment, the housing 201 may include a plurality of through-holes 215 (e.g., three) formed in the second plate (or rear plate 211a). According to an embodiment, a portion (e.g., a first portion 271a) of each of the plurality of conductive pins 271, 272, and 273 may be received in a respective through-hole 215 of the housing 201. For example, the through-holes 215 may be arranged to be spaced apart from each other and may form a single row or multiple rows.

In an embodiment, the second circuit board 206 may be disposed in the housing 201 and may be electrically connected to a display panel (e.g., the display panel 223 of FIG. 4). In an embodiment, the second circuit board 206 (e.g., a printed circuit board (PCB) and/or a printed board assembly (PBA)) may be disposed closer to the conductive pins 271, 272, and 273 than the first circuit board (e.g., the printed circuit board 203 of FIG. 4). According to an embodiment, the second circuit board 206 may be disposed closer to the display (e.g., the display 220 of FIG. 4) than the flexible circuit board 281. For example, the second circuit board 206 and the conductive pins 271, 272, and 273 may be disposed adjacent to each other on opposite sides of one side of the electronic device 101 where the first circuit board 203 is located. According to an embodiment, the second circuit board 206 may at least partially overlap the conductive pins 271, 272, and 273 (e.g., the first conductive pin 271) along an axis (or direction), such as the direction in which the display faces or the Z-axis direction.

In an embodiment, a shielding member 261 (e.g., a shield can) may be disposed on one surface of the second circuit board 206. According to an embodiment, the shielding member 261 may be disposed on the rear surface (e.g., the -Z direction surface) of the second circuit board 206. According to an embodiment, the shielding member 261 may at least partially face the second portions 271b of the conductive pins 271, 272, and 273 (e.g., the first conductive pin 271). For example, the shielding member 261 may be coupled to the second circuit board 206 by surface mounting (e.g., soldering).

According to an embodiment, the electronic device 101 may further include a digitizer module (not shown) configured to detect a touch sensing circuit, a pressure sensor capable of measuring the intensity (pressure) of a touch, and/or a magnetic field-based stylus pen. According to an embodiment, the display (e.g., the display 220 of FIG. 4) or the display panel (e.g., the display panel 223 of FIG. 4) may be coupled to or disposed adjacent to the digitizer module (not shown).

Referring to FIG. 13, in an embodiment, the digitizer module (not shown) may include a digitizer circuit board (not shown) and the metal sheet 262. According to an embodiment, the metal sheet 262 may be disposed on the second circuit board 206 and may be electrically connected to a ground region of the second circuit board 206. For example, the metal sheet 262 may be a metal (e.g., aluminum) plate member. According to an embodiment, the metal sheet 262 may be configured to maintain the rigidity of a shielding sheet (not shown) provided between the display 220, the digitizer circuit board, and/or between the display 220 and the digitizer circuit board. However, the material, shape, and/or arrangement of the metal sheet 262 is not limited to the above description. According to an embodiment, while maintaining the function of providing a conductive region electrically connected to the first conductive pin 271a through the shielding member 261 and/or the conductive members 282a and 283, the material, shape, and/or arrangement may be modified as necessary. In an embodiment, the metal sheet 262 may form part of not only the digitizer module (not shown) but also electrical/electronic components (e.g., a wireless charging module) or the support structure of the electronic device 101.

Referring to FIG. 13, in an embodiment, at least a portion of the board assembly 280 may be positioned between the conductive pins 271, 272, and 273 and the second circuit board 206. In an embodiment, the board assembly 280 may include a flexible circuit board 281 (e.g., a flexible printed circuit board (FPCB) and/or a rigid-flexible printed circuit board (RFPCB)) and a first conductive member 282 (e.g., a C-clip) and a second conductive member 283 (e.g., a C-clip), which are disposed on the flexible circuit board 281.

In an embodiment, the flexible circuit board 281 may be configured to electrically connect the conductive pins 271, 272, and 273 to the first circuit board (e.g., the printed circuit board 203 of FIG. 4). In an embodiment, the first circuit board 203 and the conductive pins 271, 272, and 273 may be disposed adjacent to each other on opposite sides of the electronic device 101, and the flexible circuit board 281 may extend between the first circuit board 203 and the conductive pins 271, 272, and 273. According to an embodiment, the flexible circuit board 281 may at least partially overlap the second circuit board 206 and/or the conductive pins 271, 272, and 273 (e.g., the first conductive pin 271) along an axis or direction, such as the direction in which the display faces or the Z-axis direction. In an embodiment, an adhesive layer (e.g., the adhesive layer 2811 of FIGS. 7A and 9B), such as an adhesive or a double-sided tape, may be provided around the second conductive member 283 on the front surface of the flexible circuit board 281 where the second conductive member 283 is disposed. According to an embodiment, the adhesive layer 2811 may connect the flexible circuit board 281 to a non-conductive member (e.g., the non-conductive member 212 of FIGS. 10A and 10B).

In an embodiment, the first conductive member 282 and the second conductive member 283 may be mounted on different surfaces of the flexible circuit board 281. Referring to FIG. 13, according to an embodiment, the first conductive member 282 may be disposed on one surface (or rear surface) of the flexible circuit board 281 facing the conductive pins 271, 272, and 273. According to an embodiment, the second conductive member 283 may be disposed on the opposite surface of the flexible circuit board 281 from the surface on which the first conductive member 282 is mounted, or on the surface (i.e., the front surface) of the flexible circuit board 281 facing the display. For example, the first conductive member 282 may be positioned between the conductive pins 271, 272, and 273 and the flexible circuit board 281. For example, the second conductive member 283 may be positioned between the flexible circuit board 281 and the second circuit board 206. According to an embodiment, the first conductive member 282 may be arranged to electrically connect the conductive pins 271, 272, and 273 to the flexible circuit board 281. According to an embodiment, the second conductive member 283 may be arranged to electrically connect the flexible circuit board 281 to the second circuit board 206. In an embodiment, the first conductive member 282 and the second conductive member 283 may extend a ground region electrically connected to the first conductive pin 271 to a ground region of the second circuit board 206 and the metal sheet 262. The first conductive member 282 and/or the second conductive member 283 may be coupled to the flexible circuit board 281, for example, by surface mounting (e.g., soldering).

Referring to FIG. 13, in an embodiment, the plurality of conductive pins 271, 272, and 273 may be disposed adjacent to a second plate (e.g., the rear plate 211a of FIG. 4) that forms the rear surface 210B of the electronic device 101 or the housing 201. For example, the conductive pins 271, 272, and 273 may be connection members or connectors, such as pogo pins, with a portion exposed to the outside of the electronic device 101. According to an embodiment, the conductive pins 271, 272, and 273 may be spaced apart from one another side by side or in parallel. For example, the conductive pins 271, 272, and 273 may be seated on and/or fixed to a portion of a second region 232 that forms an inner surface (e.g., a surface in the +Z direction) of the rear plate 211a. According to an embodiment, the conductive pins 271, 272, and 273 may be configured to be electrically separated or isolated from one another.

In an embodiment, the plurality of conductive pins 271, 272, and 273 (e.g., three) may include a first conductive pin 271, a second conductive pin 272, and a third conductive pin 273. According to an embodiment, the first conductive pin 271 may be a ground terminal and may be grounded to a ground of the first circuit board (e.g., the printed circuit board 203 of FIG. 4) through the flexible circuit board 281. According to an embodiment, the second conductive pin 272 and/or the third conductive pin 273 may be configured to receive power from an external electronic device or to transmit and/or receive data such as input signals. According to an embodiment, each of the conductive pins 271, 272, and 273 may be electrically connected to the flexible circuit board 281 through a plurality of first conductive members 282 (e.g., C-clips). According to an embodiment, the conductive pins 271, 272, and 273 may be electrically connected to the first circuit board (e.g., the printed circuit board 203 of FIG. 4) through the flexible circuit board 281.

Referring to FIGS. 13 and 14, in an embodiment, the first conductive pin 271 may include a first portion 271a and a second portion 271b. According to an embodiment, the first portion 271a and the second portion 271b of the first conductive pin 271 may be seated in the second region 232 (or non-conductive region) of the housing 201. In an embodiment, the first portion 271a may be disposed in a through-hole 215 of the rear plate 211a facing the second surface (or rear surface) 210B of the electronic device 101, and at least a portion thereof may be exposed to the outside of the electronic device 101. According to an embodiment, at least a part of the first portion 271a may be electrically connected or coupled to a connector provided in an external electronic device, such as a wireless charging device (e.g., a charging dock) or an input device (e.g., a keyboard). According to an embodiment, the second portion 271b may extend inward from the first portion 271a toward the inside of the electronic device 101. In an embodiment, the extending direction of the first portion 271a (e.g., the Y-axis direction) may be aligned with (e.g., parallel to) the extending direction of the second portion 271b (e.g., the Y-axis direction). According to an embodiment, an adhesive member 279, such as an adhesive or double-sided tape, may be provided between the second portion 271b and the inner surface (e.g., the +Z direction surface) of the rear plate 211a of the housing 201. In an embodiment, the above description of the first conductive pin 271 regarding the first portion 271a and the second portion 271b may equally apply to the second conductive pin 272 and/or the third conductive pin 273.

According to an embodiment, the first conductive pin 271 may be electrically connected to the flexible circuit board 281 through a plurality of first conductive members 282 (e.g., C-clips), each of which is in contact with the second portion 271b, and may be electrically connected to the first circuit board (e.g., the printed circuit board 203 of FIG. 4) through the flexible circuit board 281. According to an embodiment, the above description of the first portion 271a and the second portion 271b of the first conductive pin 271 may equally apply to the second conductive pin 272 and/or the third conductive pin 273.

Referring to FIGS. 13 and 14, in an embodiment, the conductive elastic member 274 may be positioned between the shielding member 261 and the first conductive pin 271. According to an embodiment, the conductive elastic member 274 may be disposed on the first conductive pin 271, at a position corresponding to the shielding member 261. Referring to FIG. 14, according to an embodiment, the conductive elastic member 274 may be disposed in a seating region 2712 (e.g., a recess) formed in a second portion 271b of the first conductive pin 271. According to an embodiment, the conductive elastic member 274 may be in contact with the shielding member 261 and may be elastically deformed by the shielding member 261, for example. According to an embodiment, the conductive elastic member 274 may be electrically connected to the first conductive pin 271 and the shielding member 261. According to an embodiment, the conductive elastic member 274 may extend a ground region electrically connected to the first conductive pin 271 to the shielding member 261, the ground region of the second circuit board 206 electrically connected to the shielding member 261, and the metal sheet 262.

According to embodiments of the disclosure, the electronic device 101 may include a grounding structure or an electrostatic discharge structure in which the first conductive pin 271 is grounded to a metal sheet 262 of a digitizer module (not shown) through the board assembly 280 and/or the conductive elastic member 274. Here, the metal sheet 262 may be electrically connected to the ground of the second circuit board 206. In an embodiment, external static electricity introduced into the first portion 271a of the first conductive pin 271 may flow to the second portion 271b. In an embodiment, the external static electricity transferred to the second portion 271b may be delivered in the direction of the arrows shown in FIG. 13, through the first conductive member 282, and may then be transferred to the flexible circuit board 281, the second conductive member 283, and a ground region (not shown) of the second circuit board 206, and ultimately transferred to and discharged through the metal sheet 262. According to an embodiment, the external static electricity transferred to the second portion 271b may be transferred to the shielding member 261 through the conductive elastic member 274 and ultimately transferred to and discharged through the metal sheet 262 via the ground region of the second circuit board 206.

In the exterior of an electronic device (e.g., a tablet PC), conductive pins (e.g., pogo pins) for connection to external electronic devices such as a wireless charging device (e.g., a charging dock) or an input device (e.g., a keyboard) may be exposed. For example, a portion of the conductive pin may be positioned inside the housing and may be electrically connected to the main circuit board through a flexible circuit board. When a portion of the conductive pin is exposed to the outside of the electronic device, external static electricity (hereinafter, external ESD) generated outside the electronic device may be introduced into the main circuit board through the conductive pin (e.g., a ground terminal). The external ESD transferred to the main circuit board may cause damage and malfunction of electrical/electronic components disposed on or near the main circuit board. For example, a metal plate (e.g., stainless steel) for distributing the external ESD flowing into the main circuit board may be additionally connected to the conductive pin. However, such a metal plate is limited in terms of size expansion and placement, and thus has limitations in distributing the amount of external ESD introduced into the main circuit board.

Embodiments of the disclosure are intended to at least address the above-described problems and/or disadvantages and to at least provide the advantages described below. For example, an electronic device may be provided that includes a grounding structure configured to transfer and discharge external static electricity, which is introduced through conductive pins exposed on the exterior of the electronic device, to a metal sheet of a digitizer module.

The technical problems to be solved by the present document are not limited to those mentioned above, and other technical problems not explicitly stated will be clearly understood by those of ordinary skill in the art from the following description.

According to an embodiment of the disclosure, an electronic device 101 may be provided. The electronic device may include a housing 201, a display 220, a first conductive pin 271, a first circuit board 203 disposed within the housing, a second circuit board 206 disposed within the housing and positioned closer to the first conductive pin than the first circuit board, and a board assembly 280 at least partially disposed between the second circuit board and the second portion. The first conductive pin may include a first portion 271a disposed in a through-hole 215 formed at one side of the housing, and a second portion 271b extending from the first portion toward an inside of the housing. The board assembly may include a flexible circuit board 281, at least one first conductive member 282a disposed on the flexible circuit board 281 and electrically connected to the second portion, and at least one second conductive member 283 disposed on the flexible circuit board 281 and electrically connected to the second circuit board.

According to an embodiment, the flexible circuit board may ground the first conductive pin to the first circuit board.

According to an embodiment, the second conductive member may be disposed on one surface of the flexible circuit board facing the display, and the first conductive member may be disposed on the opposite surface of the flexible circuit board.

According to an embodiment, the electronic device may further include a metal sheet 262 disposed between the display and the second circuit board.

According to an embodiment, the first conductive pin may be grounded to the metal sheet through the first conductive member, the flexible circuit board, the second conductive member, and the flexible circuit board.

According to an embodiment, the electronic device may further include a conductive shielding member 261 disposed on the second circuit board to face at least a portion of the second portion.

According to an embodiment, the first conductive pin may further include a conductive elastic member 274 disposed on a portion of the second portion and electrically connected to the shielding member.

According to an embodiment, the second portion, the conductive elastic member, and the shielding member may at least partially overlap along a given axis.

According to an embodiment, the shielding member may be electrically connected to the metal sheet, and the first conductive pin may be grounded to the metal sheet through the conductive elastic member and the shielding member.

According to an embodiment, the electronic device may further include a plurality of conductive pins 272 and 273, which are configured to receive power or data from an external electronic device and disposed to be spaced apart in parallel with the first conductive pin.

According to an embodiment, each of the plurality of conductive pins may include a first portion 272a or 273a disposed in each of a plurality of through-holes 215 formed on the one side of the housing, and a second portion 272b or 273b extending inward from the corresponding first portion into the housing.

According to an embodiment, the display may be arranged to face a first surface of the electronic device of the housing. The housing may include a rear plate 211a forming a second surface 210B of the electronic device that faces a direction opposite to the first surface 210A, and a side structure 211b at least partially surrounding a space between the first surface and the second surface.

According to an embodiment, at least a portion of the second portion of the first conductive pin may be disposed on an inner surface of the rear plate.

According to an embodiment, the through-hole may be formed through a portion of the side structure of the housing.

According to an embodiment, the through-hole may be formed through a portion of the rear plate of the housing.

According to an embodiment of the disclosure, an electronic device 101 may be provided. The electronic device may include a housing 201, a display 220 disposed on one surface of the housing, a first conductive pin 271, a first circuit board 203 disposed within the housing, a printed circuit board 206 disposed within the housing, a flexible circuit board 281, at least one first conductive member 282a disposed on one surface of the flexible circuit board and electrically connected to the second portion, and at least one second conductive member 283 disposed on the opposite surface of the flexible circuit board and electrically connected to the printed circuit board.

According to an embodiment, the electronic device may further include a metal sheet 262 disposed between the display and the printed circuit board. The first conductive pin may be grounded to the metal sheet through the first conductive member, the flexible circuit board, the second conductive member, and the flexible circuit board.

According to an embodiment, the electronic device may further include a conductive shielding member 261 disposed on the printed circuit board to face at least a portion of the second portion and electrically connected to the metal sheet, and a conductive elastic member 274 disposed on a portion of the second portion and electrically connected to the shielding member. The first conductive pin may be grounded to the metal sheet through the conductive elastic member and the shielding member.

According to an embodiment, the display may be disposed to face a first surface of the electronic device of the housing. The housing may include a rear plate 211a forming a second surface 210B of the electronic device facing in the direction opposite to the first surface 210A, and a side structure 211b at least partially surrounding the space between the first surface and the second surface. According to an embodiment, the through-hole may be formed through a portion of the rear plate or a portion of the side structure.

According to an embodiment, the electronic device may further include a main circuit board 203 disposed within the housing. The flexible circuit board may be configured to electrically connect the first conductive pin and a ground region of the main circuit board.

According to embodiments of the disclosure, it is possible to reduce the amount of external electrostatic discharge transmitted to the main circuit board through a grounding structure that distributes the external electrostatic discharge, introduced through a conductive pin exposed to the exterior of the electronic device, to a metal layer of a digitizer module. Accordingly, damage and malfunction of electrical/electronic components on or near the main circuit board due to the external electrostatic discharge can be mitigated.

The effects obtainable from the disclosure are not limited to those mentioned above, and other effects not explicitly stated may be clearly understood by those skilled in the art from the following descriptions.

Although embodiments of the disclosure have been described above, it should be understood that the foregoing embodiments are provided for illustrative purposes only and are not intended to limit the scope of the invention. Various modifications in form and details may be made without departing from the spirit and scope of the disclosure, as will be apparent to those skilled in the art, including those defined by the appended claims and their equivalents.

The electronic device (e.g., the electronic device 101 of FIGS. 1 to 6 and FIG. 13) according to an embodiment of the disclosure may be one of various types of devices. The electronic devices may include, for example, a portable communication device (e.g., a smartphone), a computer device, a portable multimedia device, a portable medical device, a camera, a wearable device, or a home appliance. The electronic devices according to an embodiment are not limited to those described above.

It should be appreciated that an embodiment of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "portion," or "circuitry". A module may be a single integral component, or a minimum unit or portion thereof, adapted to perform one or more functions. For example, according to an embodiment, the module may be implemented in a form of an application-specific integrated circuit (ASIC).

An embodiment of the disclosure may be implemented as software (e.g., the program 140) including one or more instructions that are stored in a storage medium (e.g., internal memory 136 or external memory 138) that is leadable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium leadable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-leadable storage medium (e.g., compact disc lead only memory (CD-ROM)), or be distributed (e.g., downloaded or uploaded) online via an application store (e.g., Play StoreTM), or between two user devices (e.g., smartphones) directly. If distributed online, at least portion of the computer program product may be temporarily generated or at least temporarily stored in the machine-leadable storage medium, such as memory of the manufacturer's server, a server of the application store, or a relay server.

According to an embodiment, each component (e.g., a module or a program) of the above-described components may include a single entity or multiple entities. Some of the plurality of entities may be separately disposed in different components. According to an embodiment, one or more of the above-described components may be omitted, or one or more other components may be added. Alternatively or further, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a housing (201);
a display (220);
a first conductive pin (271) including a first portion (271a) disposed in a through-hole (215) formed on one side of the housing (201), and a second portion (271b) extending from the first portion toward an inside of the housing;
a first circuit board (203) disposed in the housing;
a second circuit board (206) disposed in the housing and positioned closer to the first conductive pin than the first circuit board; and
a board assembly (280) at least partially disposed between the second circuit board and the second portion,
wherein the board assembly (280) comprises:
a flexible circuit board (281);
at least one first conductive member (282a) disposed on the flexible circuit board and electrically connected to the second portion; and
at least one second conductive member (283) disposed on the flexible circuit board and electrically connected to the second circuit board.

2. The electronic device of claim 1, wherein the flexible circuit board is configured to electrically connect the first conductive pin and a ground region of the first circuit board.

3. The electronic device of claim 1 or 2,
wherein the second conductive member is disposed on one surface of the flexible circuit board facing the display, and the first conductive member is disposed on an opposite surface of the flexible circuit board from the one surface.

4. The electronic device of any one of claims 1 to 3, further comprising a metal sheet (262) disposed between the display and the second circuit board.

5. The electronic device of claim 4,
wherein the first conductive pin is grounded to the metal sheet through the first conductive member, the flexible circuit board, the second conductive member, and the flexible circuit board.

6. The electronic device of claim 4 or 5, further comprising a conductive shielding member (261) disposed on the second circuit board to face at least a portion of the second portion.

7. The electronic device of claim 6, wherein the first conductive pin further comprises a conductive elastic member (274) disposed at a portion of the second portion and electrically connected to the shielding member.

8. The electronic device of claim 7, wherein the second portion, the conductive elastic member, and the shielding member at least partially overlap with each other along an axis.

9. The electronic device of claim 7 or 8,
wherein the shielding member is electrically connected to the metal sheet, and the first conductive pin is grounded to the metal sheet through the conductive elastic member and the shielding member.

10. The electronic device of any one of claims 1 to 9, further comprising:
a plurality of conductive pins (272, 273) configured to receive power or data from an external electronic device and disposed to be spaced apart from and parallel to the first conductive pin.

11. The electronic device of claim 10,
wherein each of the plurality of conductive pins includes a first portion (272a, 273a) disposed in a plurality of through-holes (215) formed on the one side of the housing, and a second portion (272b, 273b) extending inward from the first portion into the housing.

12. The electronic device of any one of claims 1 to 11,
wherein the display is disposed to face a first surface (210A) of the electronic device of the housing, and
wherein the housing comprises:
a rear plate (211a) forming a second surface (210B) of the electronic device, the second surface facing in a direction opposite to the first surface; and
a side structure (211b) at least partially surrounding a space between the first surface and the second surface.

13. The electronic device of claim 12, wherein at least a portion of the second portion of the first conductive pin is disposed on an inner surface of the rear plate.

14. The electronic device of claim 12 or 13, wherein the through-hole is formed through a portion of the side structure of the housing or a portion of the rear plate of the housing.

15. An electronic device (101) comprising:
a housing (201);
a display (220);
a first conductive pin (271) including a first portion (271a) disposed in a through-hole (215) formed on one side of the housing (201), and a second portion (271b) extending from the first portion toward an inside of the housing;
a printed circuit board (206) disposed in the housing;
a flexible circuit board (281);
at least one first conductive member (282a) disposed on one surface of the flexible circuit board (281) and electrically connected to the second portion; and
at least one second conductive member (283) disposed on an opposite surface of the flexible circuit board from the one surface and electrically connected to the printed circuit board.
